# EUROPEAN PATENT SPECIFICATION

(11) **EP 1 869 835 B1**
(45) Date of publication and mention of the grant of the patent: **09.09.2015**
(21) Application number: 06749860.0
(22) Date of filing: 12.04.2006
(51) Int. Cl.: H04L 12/28

(54) **A WIRELESS PATIENT MONITORING SYSTEM**
DRAHTLOSES PATIENTENÜBERWACHUNGSSYSTEM
SYSTÈME DE SURVEILLANCE DE PATIENT SANS FIL

(30) Priority: 15.04.2005 US 671935 P; 18.04.2005 US 672562 P; 12.08.2005 US 206278
(43) Date of publication of application: 26.12.2007
(73) Proprietor: Ivy Biomedical Systems, Inc., Branford, Connecticut 06405 (US)
(72) Inventor: TUCCILLO, Mark, Joseph, Southington, Connecticut 06489 (US)
(74) Representative: Reichert & Lindner Partnerschaft Patentanwälte
(86) International application number: PCT/US2006/013616
(87) International publication number: WO 2006/113263

(56) References cited:
- US-A1- 2002 013 518
- US-A1- 2002 109 621
- US-A1- 2003 174 049

## Description

### FILELD OF THE INVENTION

The invention relates to the field of patient monitoring and more specifically to the field of patient monitoring using wireless communications.

### BACKGROUND OF THE INVENTION

The monitoring of patient health parameters is an important aspect of medical care. Typically, this monitoring takes place with the patient physically wired to local devices some of which (for example ECG monitors) may have remote monitoring capabilities. Alternatively, the monitor may be a wireless monitor that communicates only with a transmitter-receiver located in the patient's room.

A problem exists with systems of this type. Specifically, movement of the patient to other locations within the hospital for specialized tests, such as x-ray or endoscopy, requires that patient monitoring cease for a potentially extended period of time. This is hazardous for the patient and results in clinicians not having up-to-date patient information prior to commencing certain procedures. What is required is a means to allow the patient to be continuously monitored without the associated hazards discussed above. The present invention addresses these issues.

U.S. patent application US 2003/174049 A1 discloses a wireless patient monitoring system comprising a first patient monitoring subsystem (identification appliance) comprising a plurality of sensors and sensor modules and a processor-transceiver in communication with said plurality of sensors and sensor modules. Said wireless patient monitoring system also comprises a plurality of clinician display subsystems (local wireless communication systems) each clinician display subsystem comprising a respective processor-transceiver and determining the frequency range of a current identification appliances.

U.S. patent application US 2002/013518 A1 also discloses a wireless patient monitoring system (system for monitoring patients) comprising a first patient monitoring subsystem (wireless patient monitor) comprising a plurality of sensors and sensor modules and a processor-transceiver in communication with said plurality of sensors and sensor modules. Said wireless patient monitoring system also comprises a plurality of clinician display subsystems (central monitoring stations). The patient monitors scan for access points and detect the access-point configuration and synchronize information. This ensures that a patient associated with a patient monitor can move about a hospital floor without loss of central monitoring.

U.S. patent application US 2002/109621 A1 also discloses a wireless patient monitoring system comprising a base unit in wireless communication with a plurality of wireless sensors attached to the body of the patient. The base unit scans its receive channels for an available channel which then becomes the default channel and then begins transmitting electrode registration data and messages on this default channel. The single base unit is constructed such that transmission of multi-channel signals is on a single digitally encoded frequency channel between the base unit transceiver and multiple electrode devices by using time division multiplexing. Thus, the single base unit communicates with multiple electrodes over a single channel and allocates a time slice to each separate electrode.

### SUMMARY OF THE INVENTION

In one aspect, the invention relates to a wireless patient monitoring system which in one embodiment has a first patient monitoring subsystem including a plurality of sensors and sensor modules; and a processor-transceiver in communication with the plurality of sensors and sensor modules; and a first clinician display subsystem including a processor-transceiver. The processor-transceiver of the first clinician display subsystem broadcasts, on a first predetermined frequency, the frequency that the processor-transceiver of the first clinician display subsystem will use to communicate with the processor-transceiver of the first patient monitoring subsystem. The processor-transceiver of the first patient monitoring subsystem then transmits and receives data on the frequency that the processor-transceiver of the first clinician display subsystem indicated that it will use to communicate with the processor-transceiver of the first patient monitoring subsystem. In another embodiment the processor-transceiver of the first patient monitoring subsystem reverts to the first frequency, if communication with the processor-transceiver of the first clinician display subsystem is lost. In another embodiment, the communication is lost due to patient movement within a hospital.

In yet another embodiment, the wireless system includes a second clinician display subsystem including a processor-transceiver. The processor-transceiver of the first patient monitoring subsystem will establish communications with the processor-transceiver of the second clinician display subsystem when communication with the processor-transceiver of the first clinician display subsystem is lost. In one embodiment the first predetermined frequency and the frequency that the processor-transceivers of first and second clinician display subsystems will use to communicate with the processor-transceiver of the first patient monitoring subsystem are different.

Another aspect of the invention relates to a patient monitoring subsystem for a wireless patient monitoring system having a first clinician display subsystem including a processor-transceiver. The patient monitoring subsystem includes a plurality of sensors and sensor modules; and a processor-transceiver in communication with the plurality of sensors and sensor modules. The first clinician display subsystem broadcasts on a first predetermined frequency a frequency that the processor-transceiver of the first clinician display subsystem will use to communicate with the processor-transceiver of the patient monitoring subsystem. The processor-transceiver of the patient monitoring subsystem then transmits and receives data on the frequency that the processor-transceiver of the first clinician display subsystem will use to communicate with the processor-transceiver of the patient monitoring subsystem.

In one embodiment, the processor-transceiver of the patient monitoring subsystem reverts to the first frequency if communication with the processor-transceiver of the first clinician display subsystem is lost. In another embodiment the communication is lost due to patient movement within a hospital. In another embodiment the wireless system further includes a second clinician display subsystem including a processor-transceiver. The processor-transceiver of the patient monitoring subsystem will establish communication with the processor-transceiver of the second clinician display subsystem when communication with the processor-transceiver of the first clinician display subsystems is lost. In another embodiment, the first predetermined frequency and the frequency that the processor-transceivers of the first and second clinician display subsystems will use to communicate with the processor-transceiver of the patient monitoring subsystem are different.

In another aspect, the wireless system includes a clinician display subsystem for a wireless patient monitoring system. The system in one embodiment includes a first patient monitoring subsystem including a processor-transceiver. The clinician display subsystem includes a processor-transceiver. In one embodiment the processor-transceiver of the clinician display subsystem broadcasts on a first predetermined frequency, the frequency that the processor-transceiver of the clinician display subsystem will use to communicate with the processor-transceiver of the first patient monitoring subsystem. In another embodiment the processor-transceiver of the first patient monitoring subsystem transmits and receives data on the frequency that the processor-transceiver of the clinician display subsystem will use to communicate with the processor-transceiver of the first patient monitoring subsystem.

In another embodiment the processor-transceiver of the patient first monitoring subsystem reverts to the first frequency if communications with the processor-transceiver of the clinician display subsystem is lost. In one embodiment the communications is lost due to patient movement within a hospital. In another embodiment the processor-transceiver of the first patient monitoring subsystem will establish communications with a processor-transceiver of a second clinician display subsystem when communication with the processor-transceiver of the clinician display subsystem is lost. In still yet another embodiment the first predetermined frequency and the frequency that the processor-transceiver of the clinician display subsystem will use to communicate with the processor-transceiver of the patient monitoring subsystem are different.

Yet another aspect of the invention is a method of communicating in a wireless patient monitoring system which in one embodiment includes a first patient monitoring subsystem including a plurality of sensors and sensor modules; and a processor-transceiver in communication with the plurality of sensors and sensor modules; and a first clinician display subsystem. The first clinician display subsystem includes a processor-transceiver. The method includes the steps of broadcasting by the processor-transceiver of the first clinician display subsystem, on a first predetermined frequency, the frequency that the processor-transceiver of the first clinician display subsystem will use to communicate with the processor-transceiver of the first patient monitoring subsystem; and transmitting and receiving by the processor-transceiver of the first patient monitoring subsystem, data on the frequency that the processor-transceiver of the first clinician display subsystem will use to communicate with the processor-transceiver of the first patient monitoring subsystem.

In one embodiment the method includes the step of reverting to the first frequency by the processor-transceiver of the first patient monitoring subsystem if communication with the processor-transceiver of the first clinician display subsystem is lost. In another embodiment the method includes the step of establishing, by the processor-transceiver of the first patient monitoring subsystem, communication with a processor-transceiver of a second clinician display subsystem when communication with the processor-transceiver of the first clinician display subsystem is lost.

### BRIEF DESCRIPTION OF THE DRAWINGS

These and further aspects of the invention can be better understood with reference to the attached specification and drawings in which:
Fig. 1 is a block diagram of an overview of an embodiment of the patient monitoring system of the invention;
Fig. 2 is a block diagram of an embodiment of the patient monitoring subsystem of the invention;
Fig. 2a is a schematic block diagram of an embodiment of the connections between the leads and the lead select multiplexer;
Fig. 3 is a block diagram of an embodiment of the clinician display subsystem of the invention; and
Fig. 4 is an embodiment of a data structure transmitting data according to an embodiment of the protocol of the invention.

### DESCRIPTION OF A PREFERRED EMBODIMENT

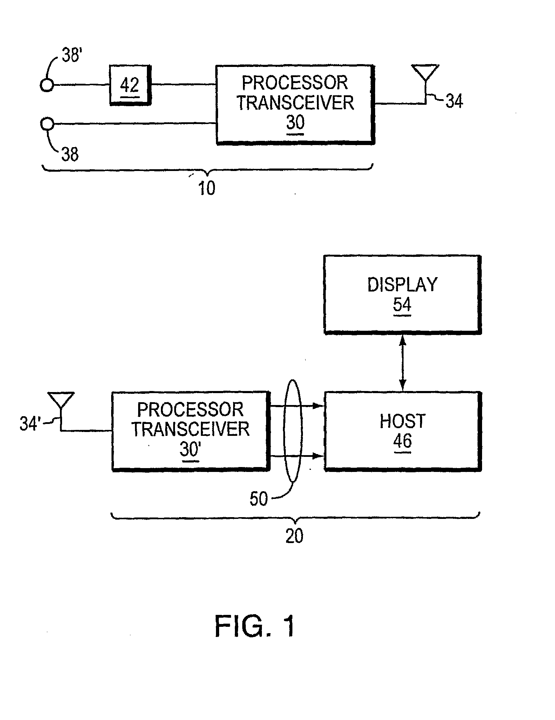

In brief overview and referring to Fig. 1, an embodiment of the wireless system of the invention includes a patient monitoring subsystem 10 and a clinician display subsystem 20. The patient monitoring subsystem 10 includes a processor-transceiver 30, an antenna 34 and a series of sensors 38 and sensor modules 42. A sensor module 42 is in communication with a sensor 38' and provides a signal to the processor-transceiver 30 that is not simply the raw sensor signal. The clinician display subsystem 20 includes an antenna 34' in communication with a processor-transceiver 30' which in turn is connected to a host processor 46 by way of UART or distal I/O data ports 50. The data processed by the host processor 46 is displayed to the clinician on a display 54.

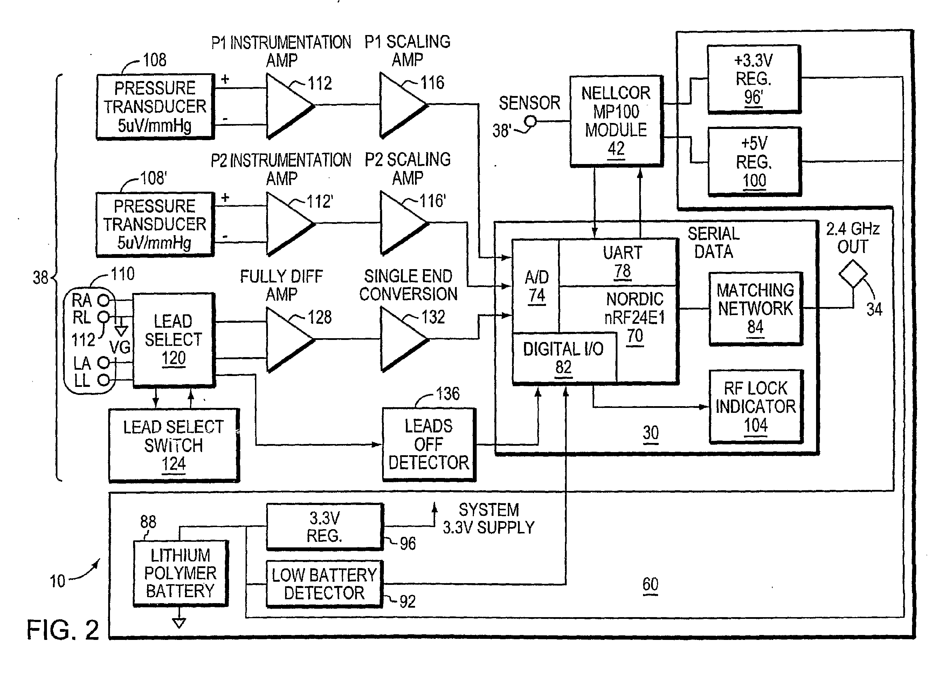

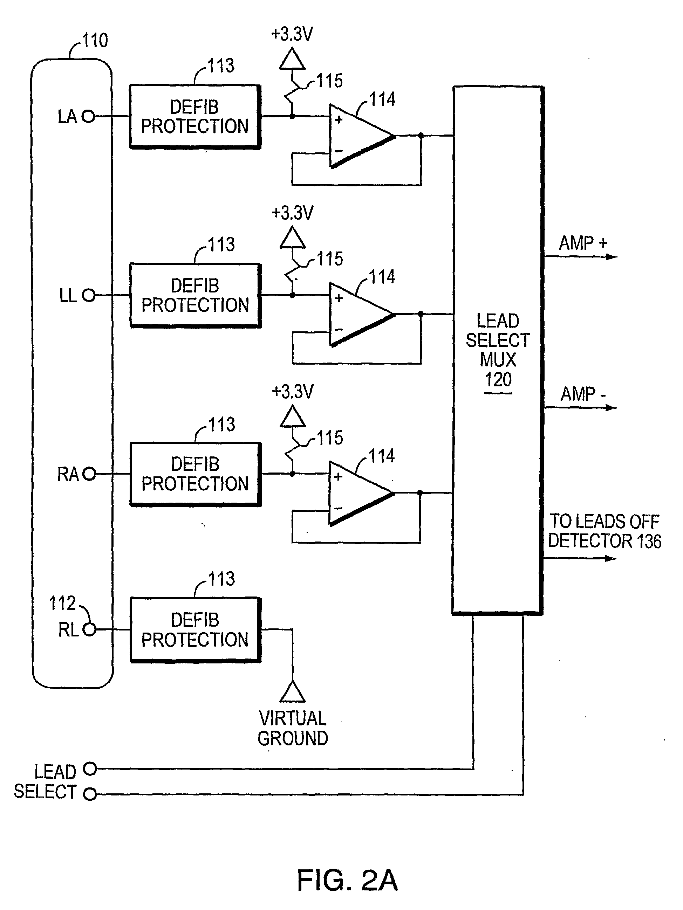

In more detail and referring to Fig. 2, the patient monitoring subsystem 10 of Fig. 1 includes a processor-transceiver 30, a series of sensors 38, sensor modules 42, antenna 34 and power subsystem 60. In the embodiment shown, the processor-transceiver 30 is an nRF24E1 made by Nordic Semiconductor ASA (Tiller, Norway). This device is a 2.4GHz RF transceiver with an embedded 8051 micro-controller 70, a multi-channel 12 bit A/D converter 74, a UART 78 and a digital I/O port 82. This device has a clock based processor, operates at 1.9 volts and has no external bus.

The transceiver portion of the chip is connected to a matching network 84 to impedance match the antenna 34. The transceiver portion of the chip can be set to operate on any one of 80 frequencies in the 2.4GHz ISM band.

The power subsystem 60 includes a non-magnetic battery 88 in the form of a lithium polymer, which provides 3.7V at 2.1 A hours and a low battery detector 92 which monitors the battery charge. Two 3.3 V regulators 96, 96' provide regulated voltage to the processor-transceiver 70 and the sensor modules 42. A 5V regulator 100 also provides power to the sensor modules 42 as needed. The integral digital I/O portion 82 both receives input from the low battery detector 92 and also produces an output signal to the RF lock indicator 104 that the RF frequency has been detected and is locked onto.

The embodiment depicted is shown with three sets of sensors 38 and sensor modules 42, but other sensors may be included. The embodiment shown includes two pressure transducers 108, 108'; ECG leads 110; and a pulse oximeter 42. In more detail, the two pressure transducers 108,108' have a differential output and have resolution of 5µV/mmHg. The output terminals of the transducers 108, 108' are connected to the respective differential input terminals of instrumentation amplifiers 112,112'. The respective output terminals of the instrumentation amplifiers 112, 112' are connected to the input terminals of their respective scaling amplifiers 116,116'. Thus the differential pressure signal monitored by the transducers 108,108' is converted to a single ended output and amplified. The amplified signal is the input signal to a respective channel of the A/D converter 74.

Similarly, the ECG sensors or leads 110 are connected to a lead select multiplexer 120 which has its control leads controlled by a lead select switch 124 that is settable by the clinician. The lead select switch 124 chooses one of three lead configurations. The first configuration (Lead I) is the differential voltage between the right arm and the left arm leads; the second configuration (Lead II) is the differential voltage between the left leg and the right arm leads; and the third configuration (Lead III) is the differential voltage between the left leg and the left arm leads. The right leg lead 112 is always used as the reference lead. The reference lead acts as a virtual ground, and is at half the regulated power supply or 1.65V.

The output signals from the selected leads are the differential input signals to a differential amplifier 128. The differential output of the differential amplifier 128 is converted by a second differential amplifier 132 to a single ended output. This single ended output signal is the input signal to the A/D converter 74. One output of the fully differential amplifier 128 is the input signal to a leads-off detector 136. The digital output of the leads-off detector 136 is an input signal to the digital I/O port 82. This signal is used to notify the clinician that the leads are not properly placed on the patient.

In more detail and referring to Fig. 2a the connections from the leads 110 to the lead select multiplexer 120 is shown in more detail. Each lead 110 is passed through a defibrillation protection circuit (generally 113) prior to being the positive input to a respective buffer amplifier (generally 114). Each leads 110 is pulled to the positive rail by a respective 22M ohm resistor (generally 115), before the lead signal reaches the positive input buffers amplifier 114. The negative input terminal of the input buffer, which is a high impedance unity gain amplifier, is connected to the output terminal of the buffer amplifier 114. If a lead 110 falls off, then the input is open and the voltage at the positive terminal of the buffer amplifier 114 is brought to the positive voltage rail. Within the lead select multiplexer 120, the outputs signals of the buffer amplifiers 114 are diode OR'ed together (not shown) and this in turn is the input signal applied to a voltage comparator (also not shown), which detects when the input voltage reaches about 80% of the reference voltage value. At this point the comparator output transitions and the change of voltage level is detected at the digital I/O port 82 of the processor-transceiver 70.

The A/D converter 74 has enough data acquisition resolution to handle adult ECG data. The digital output of the A/D converter 74 is the input signal to the processor-transceiver 70. The processor portion provides the encoded output signal to the transceiver portion for transmission by the processor-transceiver 70 to the antenna 34 through the matching network 84.

The sensor module 42, in this embodiment a Nellcor MP 100 pulse oximeter, processes data from the sensor 38' and passes the data to the processor-transceiver 70 as serial data. The serial data enters the processor-transceiver 70 through the UART 78.

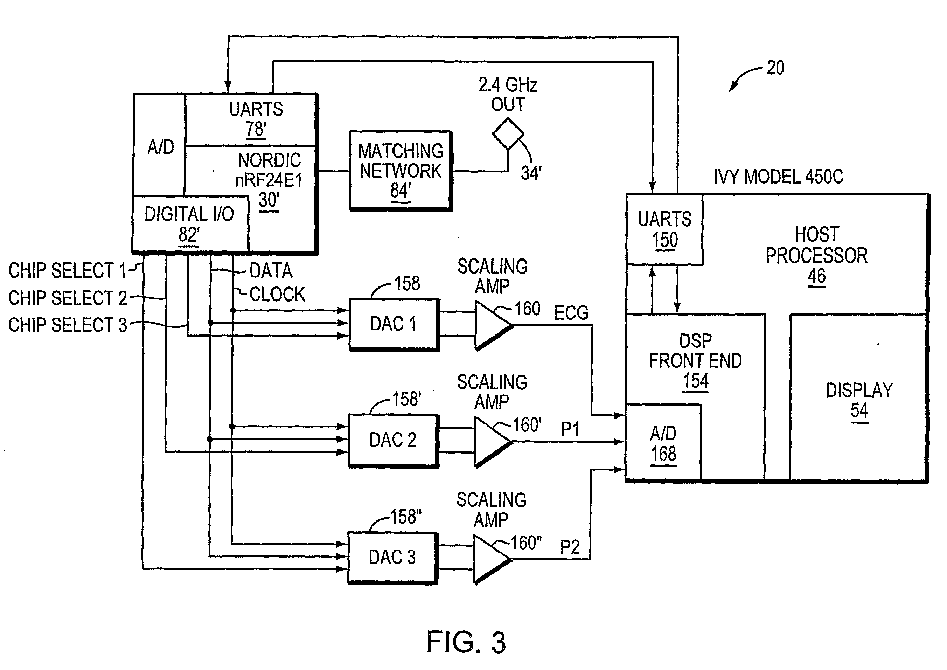

Referring to Fig 3, the clinician display subsystem 20 is shown in more detail. The processor-transceiver 30' in this embodiment is the same Nordic nRF24E1 processor-transceiver 30 that is used in the patient monitoring subsystem 10. As in the patient monitoring subsystem 10, an antenna 34' is connected to the processor-transceiver 30' through a matching network 84'. The received signals are processed by the processor and the results transferred to the host computer 46 by way of the UART 78' or the digital I/O ports 82'. In this embodiment the UART 78' of the processor-transceiver 30' is used to exchange data with the host processor 46 through the host processor UART 150. This data exchange is pre-processed by a digital signal processor front end (DSP) 154 prior to being accessed by the host processor 46 for display on the display 54. In the embodiment shown, oximeter data are transferred in this manner.

The remaining data from the pressure transducers 108, 108' and the ECG leads 110 are transferred to the host processor 46 through the digital I/O port 82'. In this embodiment the digital I/O port 82' provides the data, clock and chip select signals to three digital to analog converters (DAC) 158, 158', and 158" (generally 158). The chip select is used by the digital I/O 82' of the processor-transceiver 30' to select which DAC 158 is to make the conversion from digital to analog. The output signals from each of the DACs 158 are the input signals to respective scaling amplifiers 160, 160', 160" (generally 160). The analog output signals of each of the amplifiers 160 are the input signals to an A/D converter 168 associated with the host processor 46. Thus the ECG, and pressure signals are converted from digital form to analog form and back to digital form for processing by the DSP 154 and host processor 46. The processed output data is used to drive display 54.

Another embodiment is contemplated in which all the data from the processor-transceiver 30' is transferred to the host processor 46 through a digital port on the host system (not shown). Another preferred embodiment places a DSP chip in the patient monitoring subsystem 10, such that the DSP chip and the processor portion of the processor transceiver 30 operate on the data from the sensors 42, and sensor modules 42' before transmitting, to the clinician display subsystem 20, only a reduced amount of data, such as reduced resolution graphical display data. In this way less bandwidth is used in the transmission and less computation needs to occur at the clinician display subsystem 20.

In operation, the patient monitoring subsystem 10 has the processor-transceiver 30 initially in listen mode at a predefined frequency. The clinician display subsystem 10 has its processor-transceiver 30' broadcasting on this predetermined frequency, what frequency it will be expecting to transmit and receive on. The processor-transceiver 30 of the patient monitoring subsystem 10, at time zero, will operate in receive mode on channel 0 looking for a response. It will never transmit on any channel until a signal is detected from the processor-transceiver 30' of the clinician display subsystem 20. The processor-transceiver 30 of the patient monitoring subsystem 10 then switches itself to the transmit-and-receive frequency expected by the processor-transceiver 30' of the clinician display subsystem 20. At this point the clinician processor-transceiver 30' instructs the processor-transceiver 30 of the patient monitoring subsystem 10 to collect and transmit data. After each transmission from the processor-transceiver 30 of the patient monitoring subsystem 10, the processor-transceiver 30' of the clinician display subsystem 20 issues an acknowledgement (ACK). If the processor-transceiver 30 of the patient monitoring subsystem 10 fails to receive an ACK it returns to listen mode to determine if the processor-transceiver 30 of the clinician display subsystem 20 has changed transmission frequencies.

Looking at the operation in more detail, the protocol is an ultra low power 2.4 GHz protocol designed for short distance (less than 30 meters) highly deterministic transmission of physiological data from an on-patient instrumentation device to a single receiving and display device. Keep in mind that this simply means that transmission of data from the patient monitoring subsystem to clinician display subsystem is point to point and that any additional networking takes place through the host processor 46. Unlike other ISM band protocols, this protocol is not designed to operate within a network, but in a point to point configuration. As discussed above, it is the function of the processor-transceiver 30' of the clinician display subsystem 20 to display the data and for the host 46 to provide a bridge to a traditional network, such as 10BaseT or 802.11 network, if network transmission is desired. By unburdening the protocol from the need to operate within a network, greater robustness and absolute timing repeatability is achieved.

A feature of the protocol is automatic discovery between any number of patient monitoring subsystems 10 and up to seventy-nine clinician display subsystems within a defined operating environment. The nRF24El 2.4GHz transceiver chip with embedded 8051 micro-controller generates a 1MB burst to transmit up to twenty bytes of data in a packet. The chip employs a sixteen bit CRC for improved data integrity. The chip provides for eighty discrete channels within the 2.4GHz ISM band, permitting the processor-transceiver 30 of the patient monitoring subsystem 10 initially to be frequency neutral, and adapting to the frequency of the processor-transceiver 30'any clinician display subsystem 20. With this capability a patient could travel from one monitoring environment to another, and the processor-transceiver 30 of the patient monitoring subsystem 10 would automatically lock onto the closest unused clinician monitoring subsystem 20.

For example, prior to entering the operating room, patient preparation could take place in a dedicated room for attaching the sensors and transmitter to the patient. In this room a clinician display subsystem 20 may be present, and this subsystem 20 would be configured to transmit and receive a specific predefined frequency. The processor-transceiver 30 of the patient monitoring subsystem 10, upon powering up, would listen at a predetermined frequency (the neutral frequency) and then discover the actual transmission frequency of the clinician display subsystem 20 and switch to receive it. This would then allow the clinician to verify the quality of the data signals while any medication is given. The patient would then leave the preparation room and travel to the operating room, thus losing the communication ability with the clinician display subsystem 20 in the preparation room. The processor-transceiver 30 of the patient monitoring subsystem 10 would then reset its receive frequency to the neutral frequency again. In the operating room, there would be another clinician display subsystem 20. Again the processor-transceiver 30 of the patient monitoring subsystem 10 would discover the transmission frequency of this new clinician display subsystem 20, set itself to receive this frequency and transmit data.

It is possible to extend the number of devices which can operate within a given clinical zone from seventy nine to about five million by including a sixteen bit address assignment to the processor-transceiver 30 of each clinician display subsystem 20 (equal to seventy nine channels times 65,536). In such an embodiment, multiple clinician display subsystems 20 could operate on the same channel, but would be discriminated by their sixteen bit address. Such an approach is reasonable for implementation requiring low data rates. This is due to the fact that with address discrimination there will be a certain number of radio packet collisions which will require the need for re-transmissions. Furthermore, the transceivers require additional, time to decode the packet and to determine if the address matches the assignment. The net effect is a possible reduction in bandwidth.

The combination or protocol and hardware features result in extremely low power consumption; about 13mW of power when transmitting. The transceivers can send about 100K baud of data in one direction with a real time delay of 3mS; enough for six physiological parameters. The protocol allows for the re-transmission once of each packet if dropped. It also contains information about signal strength, patient monitoring subsystem 10 processor-transceiver 30 serial number, and battery life. The protocol also allows for about fifty kilobaud of information to be sent from the clinician display subsystem 20 back to the processor-transceiver 30 of the patient monitoring subsystem 10.

In more detail, the processor-transceivers 30, 30' have four operational states. In the first state, State_0, the processor-transceiver 30 is set to the neutral frequency, the frequency at which the processor-transceiver 30 of the patient monitoring subsystem 10 listens for the presence of a clinician display subsystem 20. The processor-transceiver 30' of the clinician display subsystem 20 at this point is broadcasting a low power RF signal (termed a beacon) out every 10mS on the neutral frequency (channel 0) indicating which channel from one to seventy-nine the processor-transceiver 30' of the clinician display subsystem 20 has been assigned and will be receiving on. The processor-transceiver 30' of each clinician display subsystem 20 within an operating environment has a unique channel assignment. After sending the beacon, the clinician processor-transceiver 30' switches to the assigned channel and listens for a response from the processor-transceiver 30 of the patient monitoring subsystem 10. If no response is received, then the clinician transceiver 30' transmits a beacon again and then again listens for a response. This continues until a response is found. All beaconing happens at -20dBM, so as to limit the coverage area to about three meters.

Once the processor-transceiver 30' of the clinician display subsystem 20 and the processor-transceiver 30 of the patient monitoring subsystem 10 have established the transmit and receive frequency, the transceivers 30, 30' are in Stat_1. In this state, the processor-transceiver 30 of the patient monitoring subsystem 10 is switched to the operating channel indicated by the beacon message from the processor-transceiver 30' of the clinician display subsystem 20. The processor-transceiver 30 of the patient monitoring subsystem 10 sends an "ACK" or acknowledgement message. The clinician transceiver 30' transmits an "RFD" or request for descriptor to the patient monitoring subsystem 10 processor-transceiver 30. The processor-transceiver 30 of the patient monitoring subsystem 10 responds with another "ACK". From here on, any received message in either direction will be responded to with an "ACK".

At this point the transceivers 30,30' have entered State_2. This is the discovery state of the system. The processor-transceiver 30 of the patient monitoring subsystem 10 will now tell the processor-transceiver 30' of the clinician display subsystem 20 about itself. The processor-transceiver 30 of each patient monitoring subsystem 10 has a hard coded unique thirty two bit serial number in read only memory which is also displayed on the patient monitoring subsystem's 10 enclosure as a six decimal digit value. The processor-transceiver 30 of the patient monitoring subsystem 10 now sends this serial number to the clinician display subsystem 20, for display and awaits the "ACK" message from the clinician transceiver 30'. All communications now occurs at full RF power or 0dBM Every message received from the processor-transceiver 30 of the patient monitoring subsystem 10 is acknowledged by the clinician transceiver 30' with an "ACK" message. In this state, if the processor-transceiver 30 of the patient monitoring subsystem 10 receives no "ACK" from the clinician transceiver 30', it will re-transmit its previous message thirty two times, and after which it will assume that it is no longer in contact with the clinician transceiver 30' with which it had been in contact and looks for another clinician transceiver 30' by returning to State_0.

If the clinician display subsystem 20 has received a response from the processor-transceiver 30 of a patient monitoring subsystem 10 that is compatible, the clinician display subsystem 20 processor-transceiver transmits a "GTD" or go-to-data message and the processor-transceiver 30 of the patient monitoring subsystem 10 returns an "ACK". The processor-transceiver 30 of every patient monitoring subsystem 10 includes a bi-color red-green LED 104 to indicate the state it is operating in; red for communications with the clinician transceiver 30' (termed a "no-lock") and green for communications with the clinician transceiver 30' (termed a "lock"). At this point the processor-transceiver 30 of the patient monitoring subsystem 10 lights the green LED, and the transceivers 30, 30' enter State_3. Patient data transmission begins. If the clinician display transceiver 30' is not expecting to communicate with the transmitting processor-transceiver 30 of the patient monitoring subsystem 10, the clinician transceiver 30' sends a "DNC" or device-not-compatible message. The processor-transceiver 30 of the patient monitoring subsystem 10 then sends an "ACK" and both devices return to State_0. The processor-transceiver 30 of a patient monitoring subsystem 10, having received a "DNC", will delay for 15 seconds before entering State_0, to allow another local patient monitoring subsystem 10, if present, a chance to lock onto the clinician display transceiver 30'.

In State_3 the continuous data transfer takes place. The basic cycle time is three mS, in which a data packet of up to nineteen bytes is sent from the processor-transceiver 30 to the patient monitoring subsystem 10 to the clinician display transceiver 30', and an "ACK" is sent from the clinician display transceiver 30' back to the processor-transceiver 30 of the patient monitoring subsystem 10. All this takes about 1.2 mS, which leaves enough time for the processor-transceiver 30 of the patient monitoring subsystem 10 to re-transmit the last packet if no "ACK" is received within 500uS of sending the packet. This data transmission sequence is repeated as long as the processor-transceiver 30 of the patient monitoring subsystem 10 receives an "ACK", and the system allows for the re-transmission of one missed packet. Due to the real time nature of the signals being transmitted and the fact that the system must be deterministic, after retransmitting the missed packet, the system must move on to the next data point if the re-transmitted packet is also lost. At the clinician monitoring missed data points are interpolated. In most cases two or three missed data points in a row will not affect the ability to process the signal. If the clinician display transceiver 30 goes for more than 5 seconds without receiving an "ACK", it will then return to State_0.

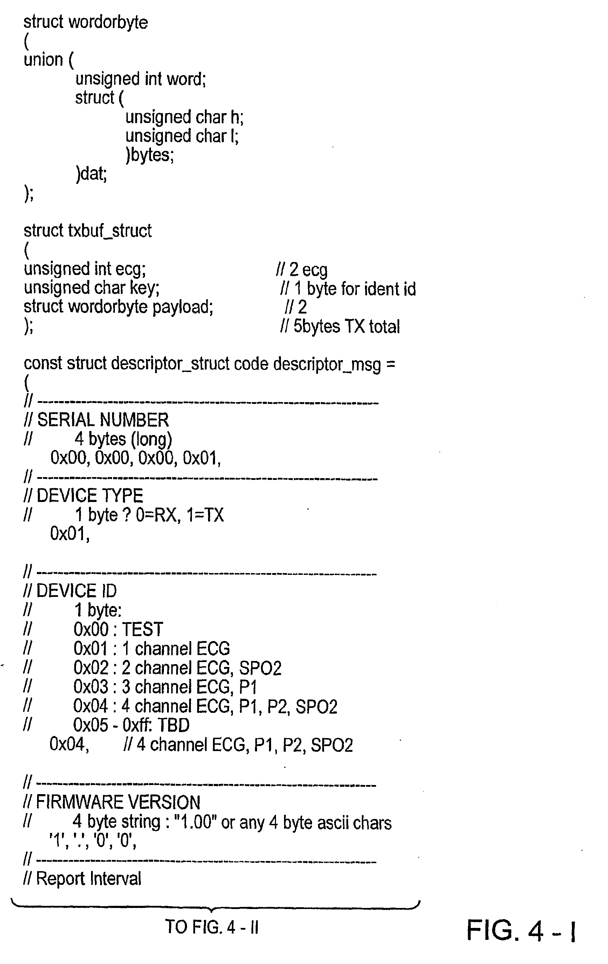

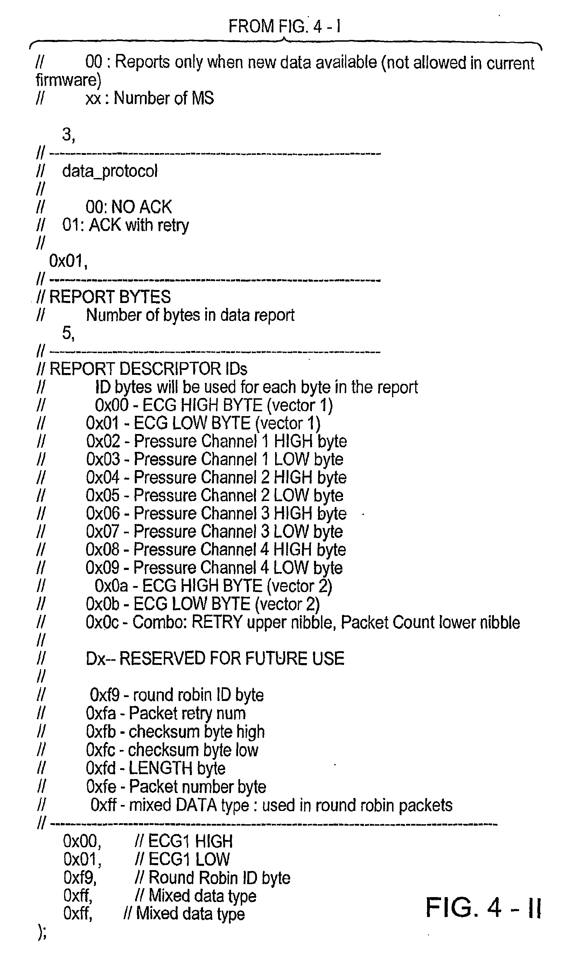

Referring to Fig. 4, the data structure is shown for on-patient monitoring suitable for an operating room, in which four parameters are sent: one twelve bit ECG vector at a three mS sampling period, two to twelve bit Invasive Pressure signals at a 25mS sample rate, and the digital stream from the Nellcor MP-100 module.

With the protocol shown additional modules and sensors can be added to meet the needs of the clinician.

The embodiments shown are exemplary and one skilled in the art will realize that modifications and changes may be made without departing from the scope of protection of the invention. The invention is intended to be limited only by the scope of the attached claims.

## Claims

1. A wireless patient monitoring system comprising:
a first patient monitoring subsystem (10) comprising:
a plurality of sensors (38, 38') and sensor modules (42); and
a processor-transceiver (30) in communication with said plurality of sensors (38, 38') and sensor modules (42); and
a plurality of clinician display subsystems (20) each clinician display subsystem (20) comprising a respective processor-transceiver (30');
said each clinician display subsystem (20) having a unique pre-assigned frequency;
wherein said processor-transceiver (30') of each of said plurality of clinician display subsystems (20) is adapted to broadcast on a first predetermined frequency the value of said respective pre-assigned frequency that said processor-transceiver (30') of one of said clinician display subsystems (20) will use to communicate with said processor-transceiver (30) of said first patient monitoring subsystem (10);
wherein said processor-transceiver (30) of said first patient monitoring subsystem (10) is adapted to switch from said first predetermined frequency to said pre-assigned frequency, so that for further communications said processor-transceiver (30) of said first patient monitoring subsystem (10) transmits and receives data on said respective pre-assigned frequency that said processor-transceiver (30') of one of said plurality of clinician display subsystems (20) will use to communicate with said processor-transceiver (30) of said first patient monitoring subsystem (10); and
**characterized in that** said wireless patient monitoring system is adapted to estblish through a protocol the communication on the pre-assigned frequency and for transmitting the data in a point to point configuration between said processor-transceiver (30) of said first patient monitoring subsystem (10) and said respective processor-transceiver (30') of a respective clinician display subsystem (20).

2. The wireless system of claim 1 wherein said processor-transceiver (30) of said first patient monitoring subsystem (10) reverts to said first predetermined frequency if communication with said processor-transceiver (30') of said current clinician display subsystem (20) is lost.

3. The wireless system of claim 2 wherein the protocol is designed to operate over a distance less than 30 meters, more particularly, the protocol can be an ultra low power 2.4 GHz protocol.

4. A method of communicating in a wireless patient monitoring system comprising a first patient monitoring subsystem (10) comprising a plurality of sensors (38, 38') and sensor modules (42); and a processor-transceiver (30) in communication with said plurality of sensors (38, 38') and sensor modules (42); and a plurality of clinician display subsystems (20), each of said plurality of clinician display subsystems (20) comprising a respective processor-transceiver (30'),
broadcasting by said processor-transceiver (30') of each of said plurality of clinician display subsystems (20), on a first predetermined frequency the value of a respective unique pre-assigned frequency that said processor-transceiver (30') of said respective clinician display subsystem (20) will use to communicate with said processor-transceiver (30) of said first patient monitoring subsystem (10); and
switching of said first patient monitoring subsystem (10) from said first predetermined frequency to said pre-assigned frequency, so that for further communications said processor-transceiver (30) of said first patient monitoring subsystem (10) transmits and receives data on said pre-assigned frequency that said processor-transceiver (30') of said respective clinician display subsystem (20) will use to communicate with said processor-transceiver (30) of said first patient monitoring subsystem (10); and
said method **characterized by**:
using a protocol for establishing the communication on the pre-assigned frequency and for transmitting the data in a point to point configuration between said processor-transceiver (30) of said first patient monitoring subsystem (10) and said respective processor-transceiver (30') of a respective clinician display subsystem (20).

5. The method of claim 4 further comprising the step of reverting to said first predetermined frequency by said processor-transceiver (30) of said first patient monitoring subsystem (10), if communication with said processor-transceiver (30') of said current clinician display subsystem (20) is lost.

6. The method of claim 5 further comprising the step of establishing, by said processor-transceiver (30) of said first patient monitoring subsystem (10), communication with a processor-transceiver (30') of another clinician display subsystem (20) when communication with said processor-transceiver (30') of said current clinician display subsystem (20) is lost.

7. The wireless patient monitoring system of claim 1 wherein said plurality of sensors (38, 38') and sensor modules (42) comprise an ECG monitor and an oximeter (42).

8. The wireless patient monitoring system of claim 7 wherein the ECG monitor comprises a plurality of leads (110) and said leads (110) are selectable by a clinician.

9. The wireless patient monitoring system of claim 8 wherein the ECG monitor comprises a differential amplifier (128) in communication with a single ended amplifier (132) in communication with a switch multiplexer (120, 124).

10. The wireless patient monitoring system of claim 3 wherein the protocol is designed so that any additional networking takes place through a host processor (46), which is connected to the processor-transceivers (30') of the clinician display subsystems (20).

11. The wireless patient monitoring system of claim 3 wherein the protocol comprises a feature of an automatic discovery between any number of patient monitoring subsystems (10) and up to seventy-nine clinician display subsystems (20) within a defined operating environment.

12. The method of claim 5 wherein said communication with said processor-transceiver (30') of said current clinician display subsystem (20) is determined to be lost by said processor-transceiver (30) of said first patient monitoring subsystem (10), if no acknowledgement message (ACK) is received from said current clinician display subsystem (20).

13. The method of claim 4 wherein the processor-transceivers (30') of the clinician display subsystems (20) display the data and a host (46), which is connected to the processor-transceivers (30'), provides a bridge to a traditional network, such as a 10 BaseT or 802.11 network, if network transmission is desired.

14. The method of claim 4 wherein the processor-transceiver (30) of the first patient monitoring subsystem (10) automatically locks onto the closest unused clinician display subsystem (20).

## Patentansprüche

1. Drahtloses Patientenüberwachungssystem umfassend:
ein erstes Patientenüberwachungssubsystem (10) umfassend:
eine Vielzahl von Sensoren (38, 38') und Sensormodulen (42); und
einen mit der Vielzahl der Sensoren (38, 38') und den Sensormodulen (42) in Verbindung stehenden Prozessor-Sender-Empfänger (30); und
eine Vielzahl von Monitorsubsystemen für Kliniker (20), wobei jedes Monitorsubsystem für Kliniker (20) einen entsprechenden Prozessor-Sender-Empfänger (30') umfasst;
jedes Monitorsubsystem für Kliniker (20) eine spezifische, zuvor zugewiesene Frequenz aufweist;
wobei der Prozessor-Sender-Empfänger (30') eines jeden aus der Vielzahl der Monitorsubsysteme für Kliniker (20) dazu ausgebildet ist, auf einer ersten vorbestimmten Frequenz den Wert der entsprechenden, zuvor zugewiesenen Frequenz zu senden, die der Prozessor-Sender-Empfänger (30') von einem der Monitorsubsysteme für Kliniker (20) zum Kommunizieren mit dem Prozessor-Sender-Empfänger (30) des ersten Patientenüberwachungssubsystems (10) verwenden wird; wobei der Prozessor-Sender-Empfänger (30) des ersten Patientenüberwachungssubsystems (10) dazu ausgebildet ist, von der ersten vorbestimmten Frequenz auf die zuvor zugewiesene Frequenz zu wechseln, so dass für weitere Kommunikationen der Prozessor-Sender-Empfänger (30) des ersten Patientenüberwachungssubsystems (10) Daten auf der entsprechenden, zuvor zugewiesenen Frequenz sendet und empfängt, die der Prozessor-Sender-Empfänger (30') eines jeden aus der Vielzahl der Monitorsubsysteme für Kliniker (20) verwenden wird, um mit dem Prozessor-Sender-Empfänger (30) des ersten Patientenüberwachungssubsystem (10) zu kommunizieren;
**dadurch gekennzeichnet, dass** das drahtlose Patientenüberwachungssystem dazu ausgebildet ist, durch ein Protokoll die Kommunikation auf der zuvor zugewiesenen Frequenz herzustellen und die Daten zwischen dem Prozessor-Sender-Empfänger (30) des ersten Patientenüberwachungssubsystems (10) und dem entsprechenden Prozessor-Sender-Empfänger (30') eines entsprechenden Monitorsubsystems für Kliniker (20) in einer Punkt-zu-Punkt-Konfiguration zu übertragen.

2. Drahtloses System nach Anspruch 1, wobei der Prozessor-Sender-Empfänger (30) des ersten Patientenüberwachungssubsystems (10) wieder auf die erste vorbestimmte Frequenz umschaltet, wenn die Kommunikation mit dem Prozessor-Sender-Empfänger (30') des aktuellen Monitorsubsystems für Kliniker (20) unterbrochen ist.

3. Drahtloses System nach Anspruch 2, wobei das Protokoll so gestaltet ist, dass es über eine Entfernung von weniger als 30 Metern funktioniert, insbesondere kann das Protokoll ein Protokoll mit einer extrem niedrigen Leistung von 2,4 GHz sein.

4. Verfahren zum Kommunizieren in einem drahtlosen Patientenüberwachungssystem umfassend
ein erstes Patientenüberwachungssubsystem (10) umfassend
eine Vielzahl von Sensoren (38, 38') und Sensormodule (42); und
einen mit der Vielzahl der Sensoren (38, 38') und Sensormodule (42) in Verbindung stehenden Prozessor-Sender-Empfänger (30); und
eine Vielzahl von Monitorsubsystemen für Kliniker (20), wobei jedes der Vielzahl der Monitorsubsysteme für Kliniker (20) jeweils einen Prozessor-Sender-Empfänger (30') umfasst;
Senden des Wertes einer entsprechenden, spezifischen, zuvor zugewiesenen Frequenz, die der Prozessor-Sender-Empfänger (30') von einem der Monitorsubsysteme für Kliniker (20) zum Kommunizieren mit dem Prozessor-Sender-Empfänger (30) des ersten Patientenüberwachungssubsystems (10) verwenden wird, auf einer ersten vorbestimmten Frequenz durch den Prozessor-Sender-Empfänger (30') eines jeden aus der Vielzahl der Monitorsubsysteme für Kliniker (20); und
Wechseln des ersten Patientenüberwachungssubsystems (10) von der ersten vorbestimmten Frequenz auf die zuvor zugewiesene Frequenz, so dass für weitere Kommunikationen der Prozessor-Sender-Empfänger (30) des ersten Patientenüberwachungssubsystems (10) Daten auf der zuvor zugewiesenen Frequenz sendet und empfängt, die der Prozessor-Sender-Empfänger (30') des entsprechenden Monitorsubsystems für Kliniker (20) verwenden wird, um mit dem Prozessor-Sender-Empfänger (30) des ersten Patientenüberwachungssubsystems (10) zu kommunizieren; und
wobei das Verfahren **dadurch gekennzeichnet ist, dass**
ein Protokoll zum Herstellen der Kommunikation auf der zuvor zugewiesenen Frequenz und zum Übertragen der Daten zwischen dem Prozessor-Sender-Empfänger (30) des ersten Patientenüberwachungssubsystems (10) und dem entsprechenden Prozessor-Sender-Empfänger (30') eines entsprechenden Monitorsubsystems für Kliniker (20) in einer Punkt-zu-Punkt-Konfiguration verwendet wird.

5. Verfahren nach Anspruch 4, ferner den Schritt umfassend, in dem der Prozessor-Sender-Empfänger (30) des ersten Patientenüberwachungssubsystems (10) wieder auf die erste vorbestimmte Frequenz umschaltet, sobald die Kommunikation mit dem Prozessor-Sender-Empfänger (30') des aktuellen Monitorsubsystems für Kliniker (20) unterbrochen ist.

6. Verfahren nach Anspruch 5, ferner den Schritt umfassend, in dem durch den Prozessor-Sender-Empfänger (30) des ersten Patientenüberwachungssubsystems (10) eine Verbindung mit einem Prozessor-Sender-Empfänger (30') eines anderen Monitorsubsystems für Kliniker (20) hergestellt wird, sobald die Kommunikation mit dem Prozessor-Sender-Empfänger (30') des aktuellen Monitorsubsystems für Kliniker (20) unterbrochen ist.

7. Drahtloses Patientenüberwachungssystem nach Anspruch 1, wobei die Vielzahl der Sensoren (38, 38') und die Sensormodule (42) einen EKG-Monitor und ein Oximeter (42) umfassen.

8. Drahtloses Patientenüberwachungssystem nach Anspruch 7, wobei der EKG-Monitor eine Vielzahl von Ableitungen (110) umfasst und die Ableitungen (110) von einem Kliniker auswählbar sind.

9. Drahtloses Patientenüberwachungssystem nach Anspruch 8, wobei der EKG-Monitor einen Differenzverstärker (128) umfasst, der mit einem Eintaktverstärker (132) kommuniziert, der mit einem Umschalt-Multiplexer (120,124) kommuniziert.

10. Drahtloses Patientenüberwachungssystem nach Anspruch 3, wobei das Protokoll so gestaltet ist, dass alle zusätzlichen Übertragungen über einen Hostprozessor (46) ablaufen, der mit den Prozessor-Sender-Empfängern (30') der Monitorsubsysteme für Kliniker (20) verbunden ist.

11. Drahtloses Patientenüberwachungssystem nach Anspruch 3, wobei das Protokoll eine automatische Erfassungsfunktion zwischen einer beliebigen Anzahl von Patientenüberwachungssubsystemen (10) und bis zu neunundsiebzig Monitorsubsystemen für Kliniker (20) innerhalb einer festgelegten Betriebsumgebung umfasst.

12. Verfahren nach Anspruch 5, wobei die Kommunikation mit dem Prozessor-Sender-Empfänger (30') des aktuellen Monitorsubsystems für Kliniker (20) durch den Prozessor-Sender-Empfänger (30) des ersten Patientenüberwachungssubsystems (10) als unterbrochen bestimmt wird, sobald vom aktuellen Monitorsubsystem für Kliniker (20) keine Bestätigungsmeldung (ACK) empfangen wird.

13. Verfahren nach Anspruch 4, wobei der Prozessor-Sender-Empfänger (30') des Monitorsubsystems für Kliniker (20) die Daten anzeigt und ein Host (46), der mit den Prozessor-Sender-Empfängern (30') verbunden ist, eine Verbindung zu einem traditionellen Netzwerk zur Verfügung stellt, wie zum Beispiel ein 10 BaseT oder ein 802.11 Netzwerk, falls Netzwerkübertragung gewünscht ist.

14. Verfahren nach Anspruch 4, wobei der Prozessor-Sender-Empfänger (30) des ersten Patientenüberwachungssubsystems (10) automatisch eine Verbindung zum nächsten unbenutzten Monitorsubsystem für Kliniker (20) herstellt.

## Revendications

1. Un système de surveillance de patients sans fil comprenant:
un premier sous-système de surveillance de patients (10) comprenant:
plusieurs capteurs (38, 38') et des modules de capteurs (42); et
un émetteur-récepteur à processeur (30) en communication avec lesdits capteurs (38, 38') et modules de capteurs (42); et
plusieurs sous-systèmes d'affichage clinicien (20), chaque sous-système d'affichage clinicien (20) comprenant un émetteur-récepteur à processeur (30');
ledit sous-système d'affichage clinicien (20) ayant une fréquence unique pré-attribuée;
dans lequel le dit émetteur-récepteur à processeur (30') de chacun desdits sous-systèmes d'affichage clinicien (20) peut diffuser à une première fréquence prédéterminée la valeur de la fréquence pré-attribuée que ledit émetteur-récepteur à processeur (30') de l'un desdits sous-systèmes d'affichage clinicien (20) utilisera pour communiquer avec ledit émetteur-récepteur à processeur (30) dudit premier sous-système de surveillance de patients (10);
dans lequel ledit émetteur-récepteur à processeur (30) dudit premier sous-système de surveillance de patients (10) peut commuter de la première fréquence pré-attribuée vers ladite fréquence pré-attribuée de sorte à ce que, pour la communication, l'émetteur-récepteur à processeur (30) du premier sous-système de surveillance de patients (10) transmet et reçoit les données à la fréquence pré-attribuée respective que l'émetteur-récepteur à processeur (30') de l'un des sous-systèmes d'affichage clinicien (20) utilisera pour communiquer avec l'émetteur-récepteur à processeur (30) du premier sous-système de surveillance de patients (10);
caractérisé en cela que le dit système de surveillance de patients sans fil est capable d'établir avec un protocole la communication à la fréquence pré-attribuée et de transmettre les données dans une configuration point à point entre l'émetteur-récepteur à processeur (30) du premier sous-système de surveillance de patients (10) et de l'émetteur-récepteur à processeur respectif (30') d'un sous-système d'affichage clinicien respectif (20).

2. Le système sans fil de la revendication 1 dans lequel l'émetteur-récepteur à processeur (30) du premier sous-système de surveillance de patients (10) inverse la première fréquence pré-attribuée si la communication avec l'émetteur-récepteur à processeur (30') du sous-système d'affichage clinicien actuel (20) est perdue.

3. Le système sans fil de la revendication 2 dans lequel le protocole est conçu pour fonctionner à une distance de moins de 30 m, plus précisément, le protocole peut être un protocole ultra basse puissance 2,4 GHz.

4. Un méthode de communication dans un système de surveillance de patients sans fil comprenant un premier sous-système de surveillance de patients (10) comprenant
plusieurs capteurs (38, 38') et des modules de capteur (42); et
un émetteur-récepteur à processeur (30) en communication avec les capteurs (38, 38') et des modules de capteur (42); et
plusieurs sous-systèmes d'affichage clinicien (20), chacun des sous-systèmes d'affichage clinicien (20) comprenant un émetteur-récepteur à processeur (30'),
diffusant avec l'émetteur-récepteur à processeur (30') de chaque sous-système d'affichage clinicien (20) à une première fréquence prédéterminée la valeur d'une fréquence unique pré-attribuée que l'émetteur-récepteur à processeur (30') du sous-système d'affichage clinicien (20) utilisera pour communiquer avec l'émetteur-récepteur à processeur (30) du premier sous-système de surveillance de patients (10); et
commutant du premier sous-système de surveillance de patients (10) de la première fréquence prédéterminée dans la fréquence pré-attribuée de sorte à ce que, pour la communication, l'émetteur-récepteur à processeur (30) du premier sous-système de surveillance de patients (10) transmette et reçoive les données à ladite fréquence pré-attribuée que l'émetteur-récepteur à processeur (30') du sous-système d'affichage clinicien (20) utilisera pour communiquer avec l'émetteur-récepteur à processeur (30) du premier sous-système de surveillance de patients (10);
ladite méthode étant caractérisé en cela qu'elle utilise un protocole pour établir la communication à la fréquence pré-attribuée et pour transmettre les données dans une configuration en point à point entre l'émetteur-récepteur à processeur (30) du premier sous-système de surveillance de patients (10) et de l'émetteur-récepteur à processeur (30') d'un sous-système respectif d'affichage clinicien (20).

5. La méthode de la revendication 4 comprenant également l'étape d'inversion de la première fréquence prédéterminée par l'émetteur-récepteur à processeur (30) du premier sous-système de surveillance de patients (10) si la communication avec l'émetteur-récepteur à processeur (30') du sous-système d'affichage clinicien actuel (20) est perdue.

6. La méthode de la revendication 5 comprenant également l'étape d'établissement, par l'émetteur-récepteur à processeur (30) du premier sous-système de surveillance de patients (10), d'une communication avec un émetteur-récepteur à processeur (30') d'un autre sous-système d'affichage clinicien (20) lorsque la communication avec l'émetteur-récepteur à processeur (30') du sous-système d'affichage clinicien actuel (20) est perdue.

7. Le système de surveillance de patients sans fil de la revendication 1 dans lequel les capteurs (38, 38') et les modules de capteurs (42) comprenant un écran ECG et un oxymètre (42).

8. Le système de surveillance de patients sans fil de la revendication 7 dans lequel l'écran ECG comprend plusieurs fils (110) et ces fils (110) peuvent être sélectionnés par un clinicien.

9. Le système de surveillance de patients sans fil de la revendication 8 dans lequel l'écran ECG comprend un amplificateur différentiel (128) en communication avec un amplificateur à simple extrémité (132) en communication avec un multiplexeur de commutation (120,124).

10. Le système de surveillance de patients sans fil de la revendication 3 dans lequel le protocole est conçu de sorte à ce que toute mise en réseau supplémentaire ait lieu à travers un processeur hôte (46) qui est connecté aux émetteurs-récepteurs à processeur (30') des sous-systèmes d'affichage clinicien (20).

11. Le système de surveillance de patients sans fil de la revendication 3 dans lequel le protocole comprend un fonction de découverte automatique entre un nombre infini de sous-systèmes de surveillance de patients (10) et jusqu'à soixante-dix-neuf sous-systèmes d'affichage clinicien (20) avec un environnement d'exploitation défini.

12. La méthode de la revendication 5 dans laquelle la communication avec l'émetteur-récepteur à processeur (30') du sous-système d'affichage clinicien actuel (20) est déterminée perdue par l'émetteur-récepteur à processeur (30) du premier sous-système de surveillance de patients (10) lorsqu'aucun message de réception (ACK) n'est reçu du sous-système d'affichage clinicien actuel (20).

13. La méthode de la revendication 4 dans laquelle les émetteurs-récepteurs à processeur (30') des sous-systèmes d'affichage clinicien (20) affichent les données et un hôte (46) qui est connecté aux émetteurs-récepteurs à processeur (30') fournit un pont vers un réseau traditionnel, tel qu'un réseau 10 BaseT ou 802.11 si la transition du réseau est réservée.

14. La méthode de la revendication 4 dans laquelle l'émetteur-récepteur à processeur (30) du premier sous-système de surveillance de patients (10) verrouille automatiquement sur le sous-système d'affichage clinicien non utilisé le plus proche.
